# EUROPEAN PATENT APPLICATION

(11) **EP 4 716 396 A1**
(43) Date of publication of application: **25.03.2026**
(21) Application number: 24823527.7
(22) Date of filing: 25.03.2024
(51) Int. Cl.: H05K 9/00, G06F 1/16, G06F 1/20, G06F 1/18

(54) **ELECTRONIC DEVICE COMPRISING SHIELD CAN AND BRACKET**

(30) Priority: 16.06.2023 KR 20230077223; 20.07.2023 KR 20230094535
(71) Applicant: Samsung Electronics Co., Ltd., Suwon-si, Gyeonggi-do 16677 (KR)
(72) Inventor: LIM, Sunghun, Suwon-si Gyeonggi-do 16677 (KR); JEONG, Ewidon, Suwon-si Gyeonggi-do 16677 (KR); KWON, Moonhyung, Suwon-si Gyeonggi-do 16677 (KR); KIM, Laekyoung, Suwon-si Gyeonggi-do 16677 (KR); MOON, Youngjoo, Suwon-si Gyeonggi-do 16677 (KR); SHIM, Seungbo, Suwon-si Gyeonggi-do 16677 (KR)
(74) Representative: Gulde & Partner
(86) International application number: PCT/KR2024/003688
(87) International publication number: WO 2024/258006

(57) **Abstract**

This electronic device may comprise: a substrate including a first surface facing a first direction; an integrated circuit provided on the first surface of the substrate; a shield can, which is provided on the first surface of the substrate and surrounds at least a portion of the integrated circuit; a bracket provided in the first direction from the shield can; and a shielding sheet provided between the bracket and the shield can. The bracket can include a first protruding area protruding from one surface (352) facing a second direction opposite to the first direction, and the shield can include a first open area provided at a position facing the first protruding area. Various other embodiments are possible.

## Description

### TECHNICAL FIELD

Various embodiments of the disclosure relate to an electronic device including a shield can and a bracket.

### BACKGROUND ART

Electronic devices may overheat due to hardware overheating or increase of external temperature. Overheated electronic devices may have the risk of hardware performance degradation or internal component damage. With the advancement of technology, electronic devices have become smaller and hardware performance has improved, leading to ongoing research into ways to reduce heat generation in the electronic devices.

For example, integrated circuits such as an application processor (AP) or central processing unit (CPU) in electronic devices used to operate at frequencies in the hundreds of megahertz (MHz) units, but recently, products in gigahertz (GHz) units are being applied and released. In addition, when noise is generated during the operation of integrated circuits, and the noise is not shielded and radiates outside the structure, it may affect other electrical components.

To address these issues, there is a growing demand for diverse material applications and structural designs. Research has been conducted to control heat generation in electronic devices and ensure shielding performance.

However, the above description should not be construed as being considered as a prior art to the description of the present disclosure, and should be construed as a related art related to the disclosure.

### DISCLOSURE OF THE INVENTION

### TECHNICAL SOLUTIONS

To prevent overheating, an electronic device may structurally incorporate a heat dissipation structure. For example, in an electronic device including an integrated circuit, such as an application processor (AP), it may be necessary for the heat dissipation structure to shield noise generated by the AP from being released externally. When noise generated by the AP is released externally, the noise may, for example, cause interference with communications in the electronic device and lead to communication degradation.

According to an embodiment of the disclosure, an electronic device including a shield can and a bracket may improve heat dissipation of the electronic device and also provide an improved shielding function.

The technical aspects to be achieved through various embodiments of the disclosure are not limited to the aforementioned aspects, and other technical aspects not mentioned will be clearly understood by one of ordinary skill in the art to which the present disclosure pertains from the following detailed description.

An electronic device according to an embodiment may include a substrate including a first surface facing a first direction, an integrated circuit provided on the first surface of the substrate, a shield can provided on the first surface of the substrate and surrounding at least a portion of the integrated circuit, a bracket provided in the first direction from the shield can, and a shielding sheet provided between the bracket and the shield can. In an embodiment, the bracket may include a first protruding area protruding from a surface facing a second direction opposite the first direction. In an embodiment, the shield can may include a first open area provided at a position facing the first protruding area.

Additionally, an electronic device according to an embodiment may include a substrate including a first surface facing a first direction, an integrated circuit provided on the first surface of the substrate, a shield can provided on the first surface of the substrate and surrounding at least a portion of the integrated circuit, a bracket provided in the first direction from the shield can and including a first protruding area protruding from a surface facing a second direction opposite the first direction, and a shielding sheet provided between the bracket and the shield can. In an embodiment, the shield can may include a first open area provided at a position facing the first protruding area and a second protruding area protruding from a surface facing the first direction. In an embodiment, the bracket may further include a second open area provided at a position facing the second protruding area.

### BRIEF DESCRIPTION OF DRAWINGS

FIG. 1 is a block diagram illustrating an electronic device in a network environment according to various embodiments.
FIG. 2A is a front perspective view of an electronic device according to an embodiment.
FIG. 2B is a rear perspective view of an electronic device according to an embodiment.
FIG. 2C is an exploded perspective view of an electronic device according to an embodiment.
FIG. 3A is an exploded perspective view of an electronic device according to an embodiment.
FIG. 3B is an exploded perspective view of an electronic device according to an embodiment.
FIG. 3C is a schematic view of a cross-section of the electronic device according to an embodiment.
FIG. 4 is a schematic view of a cross-section of a portion of an electronic device according to an embodiment.
FIG. 5A is a schematic view of a cross-section of a portion of a bracket according to an embodiment.
FIG. 5B is a schematic view of a bottom surface of a portion of a bracket according to an embodiment.
FIG. 6 is a schematic view illustrating a processing state of a bracket according to an embodiment.
FIG. 7A is a schematic view illustrating a processing state of a bracket according to an embodiment.
FIG. 7B is a schematic view illustrating a processing state of a bracket according to an embodiment.
FIG. 8A is a plan view of an electronic device according to an embodiment.
FIG. 8B is a plan view of an electronic device according to an embodiment.
FIG. 9 is a schematic view of a cross-section of a portion of an electronic device according to an embodiment.
FIG. 10 is a schematic view of a cross-section of a portion of an electronic device according to an embodiment.
FIG. 11 is a plan view of an electronic device according to an embodiment.
FIG. 12A is an exploded perspective view of an electronic device according to an embodiment.
FIG. 12B is a schematic view of a cross-section of a portion of an electronic device according to an embodiment.
FIG. 12C is a schematic view of a cross-section of a portion of an electronic device according to an embodiment.

### BEST MODE FOR CARRYING OUT THE INVENTION

Hereinafter, embodiments will be described in detail with reference to the accompanying drawings. When describing the embodiments with reference to the accompanying drawings, like reference numerals refer to like elements and a repeated description related thereto will be omitted.

It should be appreciated that various embodiments of the disclosure and the terms used therein are not intended to limit the technical features set forth herein to particular embodiments and include various changes, equivalents, or replacements for a corresponding embodiment. With regard to the description of the drawings, similar reference numerals may be used to refer to similar or related components. It is to be understood that a singular form of a noun corresponding to an item may include one or more of the things, unless the relevant context clearly indicates otherwise. As used herein, "A or B", "at least one of A and B", "at least one of A or B", "A, B or C", "at least one of A, B and C", and "at least one of A, B, or C", each of which may include any one of the items listed together in the corresponding one of the phrases, or all possible combinations thereof. Terms such as "first", "second", or "first" or "second" may simply be used to distinguish the component from other components in question, and do not limit the components in other aspects (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., by wire), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments may be implemented as software (e.g., a program 120) including one or more instructions that are stored in a storage medium (e.g., internal memory 136 or external memory 138) that is readable by a machine (e.g., an electronic device). For example, a processor of the machine (e.g., the electronic device) may invoke at least one of the one or more instructions stored in the storage medium, and execute it. This allows the machine to be operated to perform at least one function according to the at least one instruction invoked. The one or more instructions may include code generated by a compiler or code executable by an interpreter. The machine-readable storage medium may be provided in the form of a non-transitory storage medium. Here, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smartphones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components or operations may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

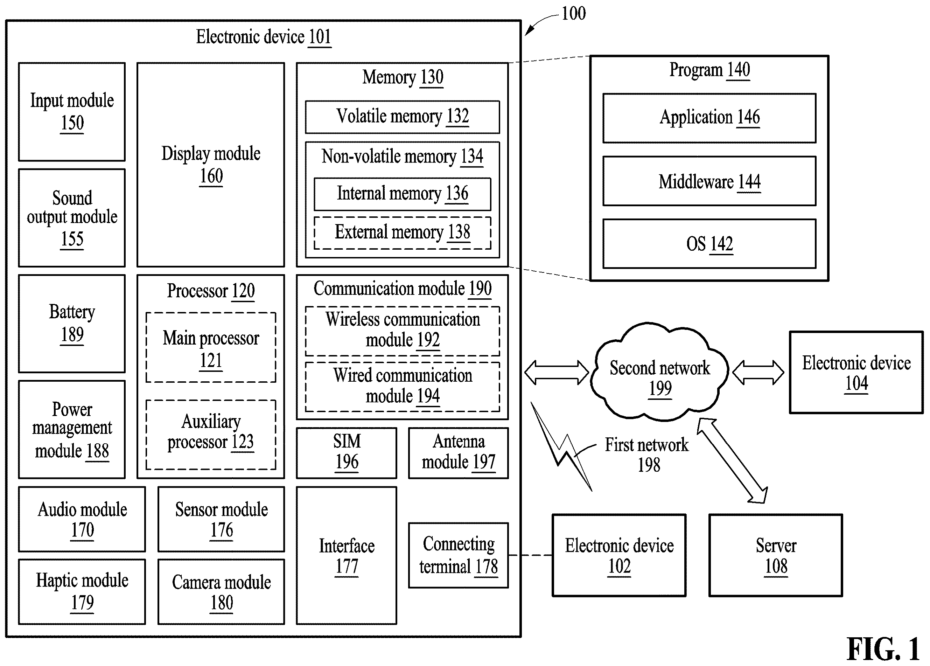

FIG. 1 is a block diagram illustrating an electronic device 101 in a network environment 100 according to various embodiments. Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added to the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121 or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an ISP or a CP) may be implemented as part of another component (e.g., the camera module 180 or the communication module 190) functionally related to the auxiliary processor 123. According to an embodiment, the auxiliary processor 123 (e.g., an NPU) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), a deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150 or output the sound via an external electronic device (e.g., an electronic device 102) (e.g., a speaker or headphone) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high-definition multimedia interface (HDMI), a universal serial bus (USB) interface, a secure digital (SD) card interface, or an audio interface.

The connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, ISPs, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more CPs that are operable independently from the processor 120 (e.g., the AP) and support a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module, or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multiple components (e.g., multiple chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a PCB, a RFIC disposed on a first surface (e.g., the bottom surface) of the PCB, or adjacent to the first surface and capable of supporting a designated high-frequency band (e.g., the mmWave band), and a plurality of antennas (e.g., array antennas) disposed on a second surface (e.g., the top or a side surface) of the PCB, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-Things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

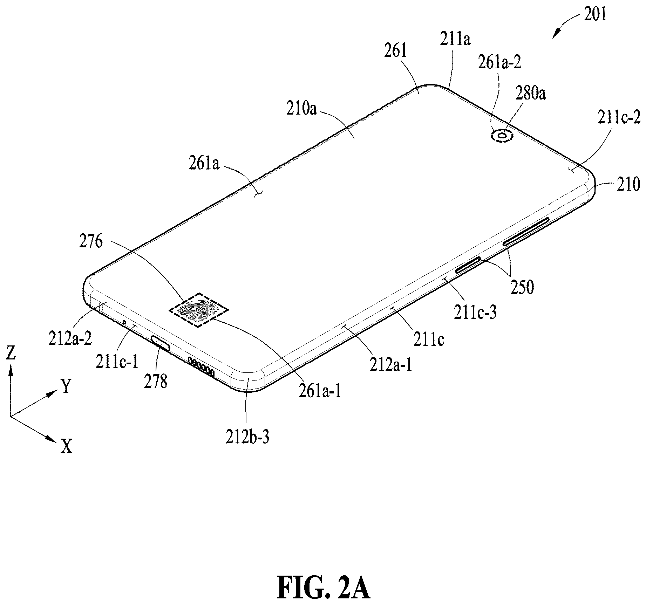

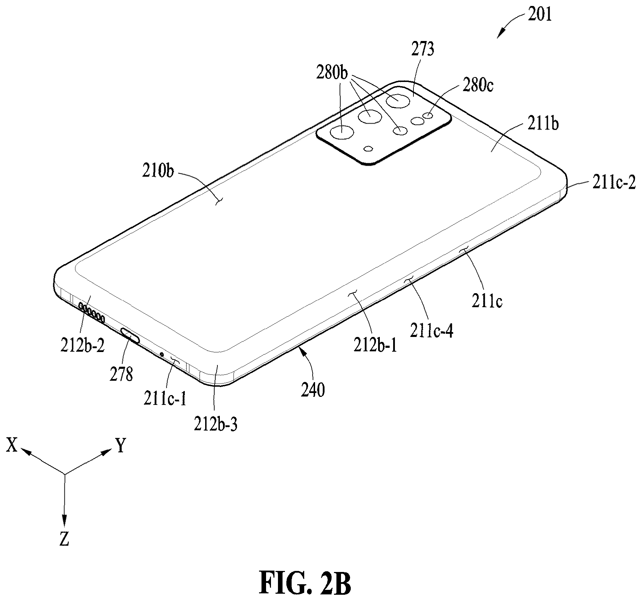

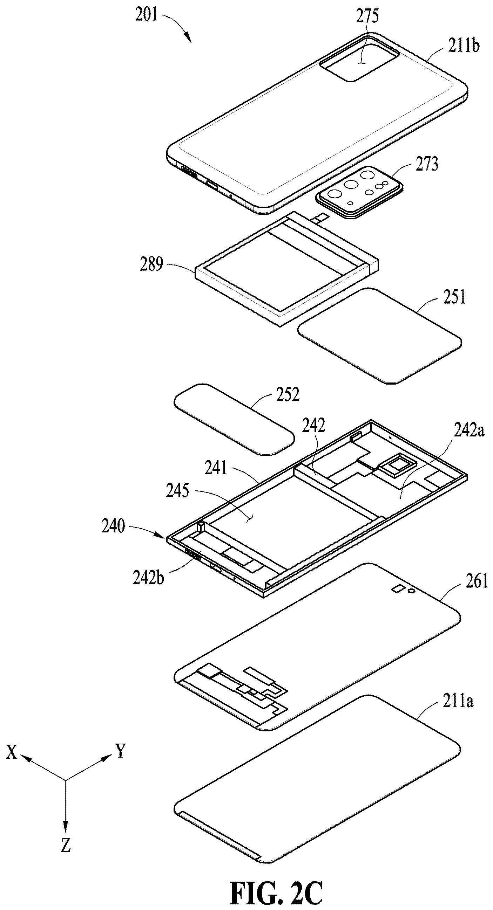

FIG. 2A is a front perspective view of an electronic device 201 according to an embodiment, FIG. 2B is a rear perspective view of the electronic device 201 according to an embodiment, and FIG. 2C is an exploded perspective view of the electronic device 201 according to an embodiment.

Referring to FIGS. 2A, 2B and 2C, the electronic device 201 (e.g., the electronic device 101 of FIG. 1) according to an embodiment may include a housing 210 forming an exterior and accommodating components therein, and the housing 210 may include a front surface 210a, a rear surface 210b, and a side surface 211c enclosing an inner space between the front surface 210a and the rear surface 210b. The housing 210 may include a plurality of side surfaces 211c extending from the front surface 210a to the rear surface 210b, and the plurality of side surfaces 211c may include a lower side surface 211c-1, an upper side surface 211c-2, a right side surface 211c-3, and a left side surface 211c-4.

In an embodiment, the front surface 210a may be formed by a front plate 211a of which at least a portion is substantially transparent. For example, the front plate 211a may include a polymer plate or a glass plate including at least one coating layer. In an embodiment, the rear surface 210b may be formed by a rear plate 211b that is substantially opaque.

For example, the rear plate 211b may be formed of coated or tinted glass, ceramic, polymer, metal (e.g., aluminum, stainless steel, or magnesium), or a combination thereof. The side surface 211c may be coupled to the front plate 211a and the rear plate 211b and may be formed by a side member 240 including metal and/or polymer. In an embodiment, the rear plate 211b and the side member 240 may be integrally and seamlessly formed. In an embodiment, the rear plate 211b and the side member 240 may be formed of substantially the same material (e.g., aluminum).

In an embodiment, the front plate 211a may include at least a portion of a plurality of first edge areas 212a-1, a plurality of second edge areas 212a-2, and a plurality of third edge areas 212a-3.

For example, the plurality of first edge areas 212a-1 may extend roundly from a portion of the front surface 210a of the front plate 211a in one direction (e.g., an X-axis direction) and toward the rear plate 211b. The plurality of second edge areas 212a-2 may extend roundly from a portion of the front surface 210a of the front plate 211a in another direction (e.g., a Y-axis direction) and toward the rear plate 211b. And, the plurality of third edge areas 212a-3 may extend roundly from a portion of the front surface 210a of the front plate 211a toward the rear plate 211b between the plurality of first edge areas 212a-1 and the plurality of second edge areas 212a-2.

In an embodiment, the rear plate 211b may include at least a portion of a plurality of fourth edge areas 212b-1, a plurality of fifth edge areas 212b-2, and a plurality of sixth edge areas 212b-3.

For example, the plurality of fourth edge areas 212b-1 may extend roundly from a portion of the rear surface 210b of the rear plate 211b in one direction (e.g., the X-axis direction) and toward the front plate 211a. The plurality of fifth edge areas 212b-2 may extend roundly from a portion of the rear surface 210b of the rear plate 211b in another direction (e.g., the Y-axis direction) and toward the front plate 211a. The plurality of sixth edge areas 212b-3 may extend roundly from a portion of the rear surface 210b of the rear plate 211b toward the front plate 211a between the plurality of fourth edge areas 212b-1 and the plurality of fifth edge areas 212b-2.

In an embodiment, the side member 240 may enclose at least a portion of the inner space between the front surface 210a and the rear surface 210b. The side member 240 may include a first support structure 241 disposed on at least a portion of the side surface 211c and a second support structure 242 connected to the first support structure 241 to form a space for disposing the components of the electronic device 201.

In an embodiment, the first support structure 241 may connect the periphery of the front plate 211a and the periphery of the rear plate 211b and surround the space between the first plate 211a and the second plate 211b, thereby forming the side surface 211c of the housing 210. In an embodiment, the second support structure 242 may be disposed inside (or in a body portion) of the electronic device 201. The second support structure 242 may be integrally formed with the first support structure 241 or may be formed separately from the first support structure 241 and connected to the first support structure 241. In an embodiment, the first support structure 241 and/or the second support structure 241 may be a component of the housing 210.

In an embodiment, at least one PCB assembly 251 or 252 may be disposed in the second support structure 242. The second support structure 242 may be, for example, connected to a ground of the at least one PCB assembly 251 or 252.

In an embodiment, a display 261 may be disposed on a surface (e.g., a lower surface (a surface in a +Z-axis direction) of FIG. 2C) of the second support structure 242, and the rear plate 211b may be disposed on the other surface (e.g., an upper surface (a surface in the -Z-axis direction) of FIG. 2C) of the second support structure 242.

In an embodiment, at least a portion of the side member 240 may be formed of a conductive material. For example, the first support structure 241 may be formed of a metal and/or conductive polymer material. In an embodiment, the second support structure 242 may be formed of a metal and/or conductive polymer material, like the first support structure 241.

In an embodiment, the rear plate 211b of the housing 210 may include a camera hole 275 to dispose a second camera module 280b and a flash 280c, and the housing 210 may include a camera decoration 273 for protecting the second camera module 280b and the flash 280c. The camera decoration 273 may be coupled to the rear plate 211b and may be visually exposed to the outside of the housing 210 by being disposed in the camera hole 275.

In an embodiment, the electronic device 201 may include the display 261 (e.g., the display module 160 of FIG. 1). In an embodiment, the display 261 may be positioned on the front surface 210a. In an embodiment, the display 261 may be exposed through at least a portion (e.g., the plurality of first edge areas 212a-1, the plurality of second edge areas 212a-2, and the plurality of third edge areas 212a-3) of the front plate 211a. In an embodiment, the display 261 may have a shape that is substantially the same as the shape of an outer edge of the front plate 211a.

In an embodiment, the edge of the display 261 may substantially coincide with the outer edge of the front plate 211a. Although not shown in the drawings, the display 261 according to various embodiments may include a touch sensing circuit (not shown), a pressure sensor (not shown) for sensing an intensity (pressure) of a touch, and/or a digitizer (not shown) for detecting a magnetic-type stylus pen (not shown).

In an embodiment, the display 261 may include a screen display area 261a that is visually exposed to display content through pixels or a plurality of cells. In an embodiment, the screen display area 261a may include a sensing area 261a-1 and/or a camera area 261a-2. In this case, the sensing area 261a-1 may overlap at least a portion of the screen display area 261a. The sensing area 261a-1 may allow transmission of an input signal related to a sensor module 276 (e.g., the sensor module 176 of FIG. 1). The sensing area 261a-1 may display content, like the screen display area 261a that does not overlap the sensing area 261a-1.

For example, the sensing area 261a-1 may display the content while the sensor module 276 is not operating. The camera area 261a-2 may overlap at least a portion of the screen display area 261a. The camera area 261a-2 may allow transmission of optical signals related to camera modules 280a and 280b (e.g., the camera module 180 of FIG. 1). The camera area 261a-2 may display content, like the screen display area 261a that does not overlap the camera area 261a-2. For example, the camera area 261a-2 may display the content while the camera modules 280a and 280b are not operating.

In an embodiment, the electronic device 201 may include the sensor module 276. The sensor module 276 may sense a signal applied to the electronic device 201. The sensor module 276 may be positioned, for example, on the front surface 210a of the electronic device 201. The sensor module 276 may form the sensing area 261a-1 in at least a portion of the screen display area 261a. For example, the sensor module 276 may also be disposed to perform its function in the inner space of the electronic device 201 without being visually exposed through the display 261. The sensor module 276 may receive an input signal transmitted through the sensing area 261a-1 and generate an electrical signal based on the received input signal. For example, the input signal may have a designated physical quantity (e.g., heat, light, temperature, sound, pressure, or ultrasound). As another example, the input signal may include a signal related to biometric information of a user (e.g., a fingerprint, a voice, and the like of a user).

In an embodiment, the electronic device 201 may include the camera modules 280a and 280b (e.g., the camera module 180 of FIG. 1). In an embodiment, the camera modules 280a and 280b may include the first camera module 280a and the second camera module 280b, and may further include a flash 280c in various embodiments.

In an embodiment, the first camera module 280a may be disposed to be visible from the outside through the front surface 210a of the housing 210, and the second camera module 280b and the flash 280c may be disposed to be visible from the outside through the rear surface 210b of the housing 210. In an embodiment, at least a portion of the first camera module 280a may be disposed in the housing 210 so as to be covered by the display 261. For example, the first camera module 280a may include an under display camera (UDC). In an embodiment, the first camera module 280a may receive an optical signal transmitted through the camera area 261a-2. In an embodiment, the second camera module 280b may include a plurality of cameras (e.g., dual cameras, triple cameras, or quad cameras). In an embodiment, the flash 280c may include a light-emitting diode or a xenon lamp.

In an embodiment, the electronic device 201 may include an input module 250 (e.g., the input module 150 of FIG. 1). The input module 250 may receive a manipulation signal of a user. The input module 250 may include, for example, at least one key input device disposed to be exposed on the side surface 211c of the housing 210.

In an embodiment, the electronic device 201 may include a connecting terminal 278 (e.g., the connecting terminal 178 of FIG. 1). In an embodiment, the connecting terminal 278 may be disposed on an outer peripheral surface of the housing 210 and for example, may be disposed on the lower side surface 211c-1 of the electronic device 201 as shown in FIG. 2A. Specifically, when the electronic device 201 is viewed in a direction (e.g., a +Y-axis direction of FIG. 2A), the connecting terminal 278 may be disposed on a central portion of the lower side surface 211c.

As illustrated in FIGS. 2A and 2B, the connecting terminal 278 may be disposed on the side surface 211c of the housing 210 that forms the exterior of the electronic device 201. However, in actual implementation, embodiments are not limited thereto, and at least a portion of the connecting terminal 278 may be disposed on the front surface 210a or the rear surface 210b of the housing 210 or may be disposed inside the housing 210. For example, although not shown in the drawings, the housing 210 in an embodiment may include a cover (not shown) for replacing a battery 289.

In an embodiment, the electronic device 201 may include the battery 289 (e.g., the battery 189 of FIG. 1) and at least one PCB assembly 251 or 252 including one or more PCBs.

In an embodiment, the electronic device 201 may include a plurality of PCB assemblies 251 and 252 and for example, the plurality of PCB assemblies 251 and 252 may include two PCB assemblies spaced apart from each other. For example, the plurality of PCB assemblies 251 and 252 may include the first circuit board assembly 251 and the second circuit board assembly 252.

The first circuit board assembly 251 in an embodiment may be a main board of the electronic device 201 that is accommodated in a first board slot 242a of the second support structure 242, and the second circuit board assembly 252 may be a sub-board of the electronic device 201 that is accommodated in a second board slot 242b of the second support structure 242.

In an embodiment, the battery 289 may be accommodated in a battery slot 245 of the second support structure 242 formed between the first board slot 242a and the second board slot 242b.

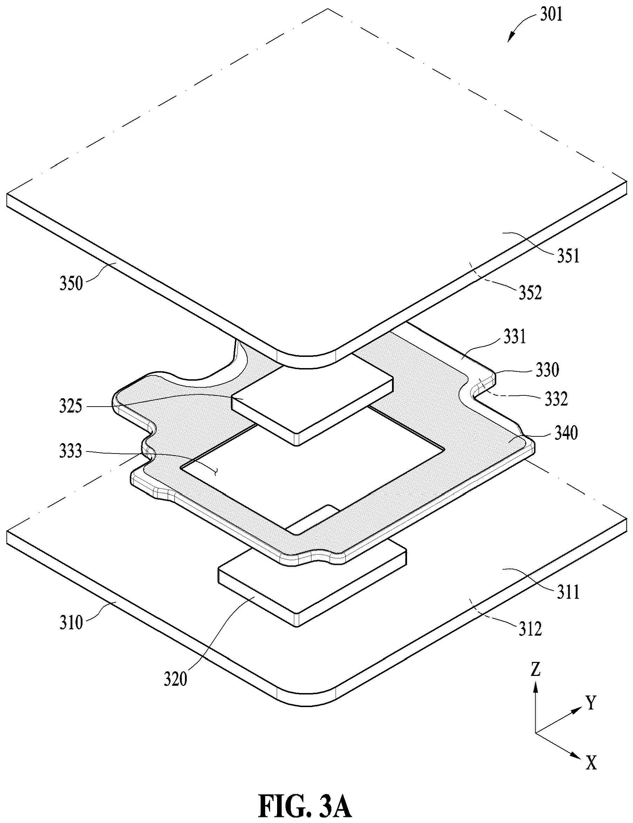

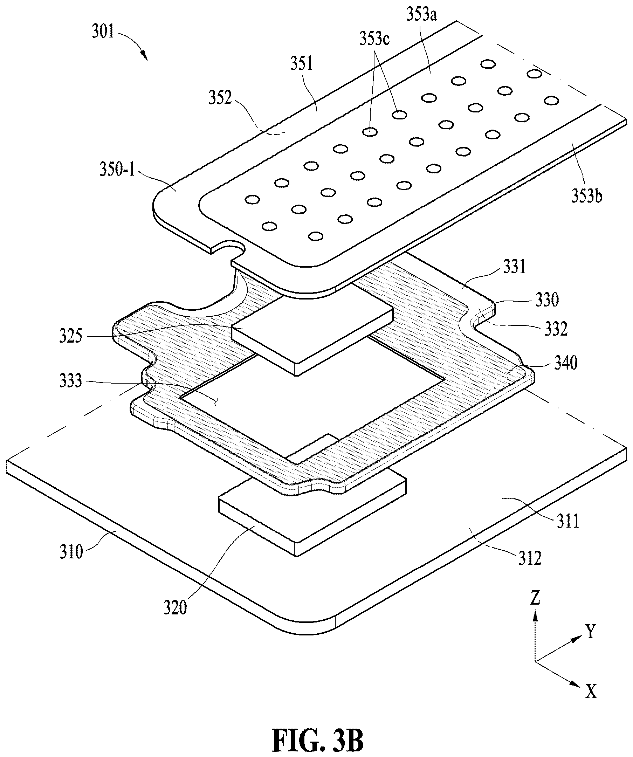

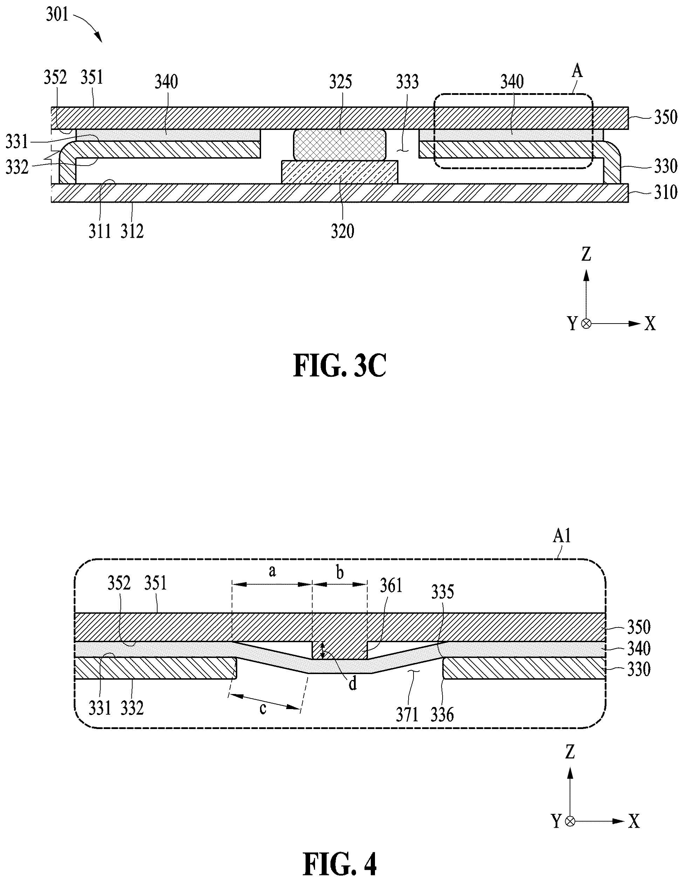

FIG. 3A is an exploded perspective view of an electronic device 301 according to an embodiment, FIG. 3B is an exploded perspective view of the electronic device according to an embodiment, and FIG. 3C is a schematic view of a cross-section of the electronic device 301 according to an embodiment.

Referring to FIGS. 3A, 3B, and 3C, the electronic device 301 according to an embodiment (e.g., the electronic device 101 of FIG. 1 , the electronic device 201 of FIGS. 2A, 2B, and 2C, or the PCB assembly 251 or 252 of FIG. 2C) may include at least one of a substrate 310, an integrated circuit 320, a shield can 330, a shielding sheet 340, and a bracket 350.

Hereinafter, the description provided above is not repeated, and it is obvious that a portion of the configuration and structure of the electronic device 301 may be replaced, added, or omitted within a scope easily understandable by one of ordinary skill in the art with reference to the following drawings and descriptions. In addition, at least one component or feature of the embodiments described above may be coupled to the electronic device 301 unless this is technically and clearly infeasible.

In an embodiment, the substrate 310 may be a core circuit board or a main circuit board of the electronic device 301. For example, the substrate 310 may be a high-specification or high-integration PCB 310 for controlling an operation of the electronic device 301.

Hereinafter, a surface on which an electronic component such as the integrated circuit 320 is provided on the substrate 310 is referred to as a first surface 311 of the substrate 310, and a surface opposite the first surface 311 of the substrate 310 is referred to as a second surface 312 of the substrate 310. For example, the first surface 311 of the substrate 310 may be a surface facing a first direction (e.g., a +Z direction or upward direction), and the second surface 312 of the substrate 310 may be a surface facing a second direction (e.g., a -Z direction or downward direction) opposite the first direction.

In an embodiment, the integrated circuit 320 may be provided on the first surface 311 of the substrate 310. However, the integrated circuit 320 described herein is an example of one of various electronic components included in the electronic device 301, and in actual implementation, the electronic device 301 may include one or more electronic components or integrated circuits 320 of various types, structures, and arrangements.

For example, the integrated circuit 320 may refer to a component that requires heat dissipation or temperature control. Alternatively, the integrated circuit 320 may be an AP or CPU configured to perform key operations, a CP, a wireless communication circuit, a graphic element, or a charging circuit.

In an embodiment, a thermal interface material (TIM) 325 may be disposed between the bracket 350 and the integrated circuit 320. The TIM 325 may be formed of a thermally conductive material.

In an embodiment, the TIM 325 may improve thermal conductivity between the bracket 350 and the integrated circuit 320. The TIM 325 may be disposed on a surface (e.g., an upper surface or a surface in the first direction) of the integrated circuit 320. The TIM 325 may be a solid TIM having a predetermined shape. The TIM 325 may be formed by applying a liquid TIM to a surface of the integrated circuit 320 and curing the applied TIM. However, this is an example, and the TIM 325 is not limited thereto.

In an embodiment, the shield can 330 may be provided on the first surface 311 of the substrate 310. The shield can 330 may be disposed between the bracket 350 and the substrate 310 and may be disposed to enclose the integrated circuit 320. The shield can 330 may include an opening 333 formed on a surface (e.g., an upper surface or a surface in the first direction). The opening 333 may be provided at a position facing the integrated circuit 320 in the first direction.

In an embodiment, the shield can 330 may protect the integrated circuit 320 by preventing foreign substances such as water, water vapor, and dust from entering a space surrounding the shield can 330. Alternatively, the shield can 330 may protect the integrated circuit 320 so that external impact is not transmitted to the integrated circuit 320.

In an embodiment, the shield can 330 may improve heat dissipation or a cooling effect inside the shield can 330 by isolating the integrated circuit 320 and an area adjacent to the integrated circuit 320 from the outside. Alternatively, the shield can 330 may prevent electromagnetic waves from entering the integrated circuit 320, and/or the shield can 330 may seal the integrated circuit 320 so that electromagnetic waves or noise generated from the integrated circuit 320 are not emitted to the outside.

In an embodiment, the shield can 330 may be made of an electromagnetic shielding material, a non-conductor and/or an insulator. For example, the shield can 330 may be made of graphite, a metal compound, or a polymer material.

Hereinafter, a surface of the shield can 330 facing the first direction or the bracket 350 is referred to as a first surface 331 of the shield can 330, and a surface opposite the first surface 331 of the shield can 330 or facing the second direction is referred to as a second surface 332 of the shield can 330.

In an embodiment, the shielding sheet 340 may be provided between the shield can 330 and the bracket 350. For example, the shielding sheet 340 may be disposed on the first surface 331 of the shield can 330. The shielding sheet 340 may shield the inside of the shield can 330 from the outside of the shield can 330. The shielding sheet 340 may be made of a conductive tape or a conductive film, or may be formed by applying a conductive paste or cream to the first surface 331 of the shield can 330 and curing the applied conductive paste or cream.

In an embodiment, the bracket 350 may be provided in a first direction from the shield can 330. For example, the bracket 350 may face the first surface 331 of the shield can 330 with the shielding sheet 340 interposed therebetween.

In an embodiment, the bracket 350 may be an internal housing disposed within an external housing (e.g., the housing 210 of FIGS. 2A, 2B, and 2C) of the electronic device 301. Without being limited thereto, the bracket 350 may be a metal material structure disposed at a position that may come into contact with the TIM 325 disposed on a surface of the integrated circuit 320.

For example, the bracket 350 may be an outer housing or inner housing of the electronic device 301, or a bezel or a cover of the electronic device 301. The bracket 350 may be thermally connected to a heat dissipation structure.

In an embodiment, the bracket 350 may be a heat dissipation chamber or a heat dissipation structure. For example, as illustrated in FIG. 3B, the bracket 350 may be a vapor chamber 350-1.

In an embodiment, the vapor chamber 350-1 may be an embodiment of the bracket 350, or part of or all of the bracket 350. The vapor chamber 350-1 may include a first plate 353a and a second plate 353b. The first plate 353a and the second plate 353b may be made of a rigid material or a material having heat dissipation performance, and may be made of, for example, a metal material or a synthetic resin.

In an embodiment, a sealed space may be provided inside the first plate 353a and the second plate 353b. A wick structure may be provided in the sealed space. The wick structure may be formed of a copper screen mesh, a working fluid, or woven wire.

In an embodiment, a plurality of fillers 353c may be formed on a surface of the first plate 353a. The plurality of fillers 353c may protrude from the first plate 353a in a direction toward the second plate 353b, so that at least a partial area of the plurality of fillers 353c may come into contact with the wick structure.

Hereinafter, the electronic device 301 of various embodiments of the disclosure is described with reference to the bracket 350 illustrated in FIG. 3A, but the structure, shape, and function of the bracket 350 in actual implementation are not limited thereto, and for example, the bracket 350 may be replaced with the vapor chamber 350-1 of FIG. 3B, and the bracket 350 and descriptions related thereto may be applied to the vapor chamber 350-1 in the same or similar manner.

In an embodiment, the bracket 350 may be made of a conductive material, such as a metallic material. The TIM 325 may be disposed between the bracket 350 and the integrated circuit 320, and at least a portion of heat generated in the integrated circuit 320 may be transferred to the bracket 350 through the TIM 325.

Hereinafter, a surface of the bracket 350 facing the first direction is referred to as a first surface 351 of the bracket 350, and a surface opposite the first surface 351 of the bracket 350 or facing the second direction is referred to as a second surface 352 of the bracket 350.

FIG. 4 is a schematic view of a cross-section of a portion of the electronic device 301 according to an embodiment. Specifically, FIG. 4 is a diagram illustrating area A1, which is a portion of area A shown in FIG. 3C.

Referring to FIG. 4, the electronic device 301 according to an embodiment may include a first protruding area 361 and a first open area 371.

Hereinafter, the description provided above is not repeated, and it is obvious that a portion of the configuration and structure of the electronic device 301 may be replaced, added, or omitted within a scope easily understandable by one of ordinary skill in the art with reference to the following drawings and descriptions. In addition, at least one component or feature of the embodiments described above may be coupled to the electronic device 301 unless this is technically and clearly infeasible.

In an embodiment, the first protruding area 361 may be provided on the second surface 352 of the bracket 350. The first protruding area 361 may be formed to protrude in a second direction (e.g., a -Z direction) from the second surface 352 of the bracket 350.

For example, in an embodiment where the bracket 350 is a vapor chamber (e.g., the vapor chamber 350-1 of FIG. 3B), the first protruding area 361 may be formed on a second plate (e.g., the second plate 353b of FIG. 3B).

In an embodiment, the first protruding area 361 may press the shielding sheet 340. The first protruding area 361 may protrude more than other areas of the second surface 352 of the bracket 350 so as to press the shielding sheet 340 and come into contact with the shielding sheet 340.

In an embodiment, the first open area 371 may be provided in the shield can 330. The first open area 371 may be provided at a position facing the first protruding area 361. The first open area 371 may be a space for positioning the first protruding area 361 and the shielding sheet 340 protruding in the second direction by the first protruding area 361.

In an embodiment, the first protruding area 361 and the first open area 371 may provide contact stability between the bracket 350 and the shielding sheet 340, and may improve the shielding performance of the shield can 330 and the shielding sheet 340 of the electronic device 301.

In an embodiment, when the shielding sheet 340 and the bracket 350 do not make contact or a poor contact occurs, the shield can 330 and the bracket 350 may not be electrically conductive, and the inside of the shield can 330 may not be shielded from the outside.

For example, the bracket 350 may be spaced or separated from the shielding sheet 340 by an amount of TIM 325 applied or by a mechanical tolerance of the shield can 330 and the bracket 350. In this case, electromagnetic waves and noise generated from the integrated circuit 320 may be emitted to the outside of the shield can 330 and may affect the operation of other electronic components.

In an embodiment, the first protruding area 361 and the first open area 371 may ensure electrical or physical connection of the shielding sheet 340 and the bracket 350, or may improve the shielding performance of the shield can 330. Alternatively, the electronic device 301 may prevent shielding defects due to mechanical tolerance and improve production yield and efficiency through the first protruding area 361 and the first open area 371.

In an embodiment, the first open area 371 may be formed as a hole opening from the first surface 331 of the shield can 330 facing the first direction to the second surface 332 facing the opposite direction. The first open area 371 formed as a hole may be relatively easy to manufacture compared to a case where the first open area 371 is formed as a groove, and it may be easier to design the electronic device 301 since there is less restriction on the height of the first protruding area 361.

Although not shown in the drawings, the first open area 371 of an embodiment may be formed as a groove that is sunken inward from the first surface 331 of the shield can 330. The first open area 371 formed as a groove may relatively improve the durability of the shield can 330 compared to a case where the first open area 371 is formed as a hole.

Hereinafter, an example method of calculating a minimum diameter (e.g., a diameter in an X direction) of the first open area 371 is described.

In an embodiment, a minimum diameter of the first open area 371 may be calculated as 'a+b+a'. Here, a may be half of a horizontal length (e.g., a length in the X direction) of an area where the shielding sheet 340 is expanded by the first protruding area 361, or a horizontal distance from an end (e.g., an end in a -X direction) of the first open area 371 to an end (e.g., an end in the -X direction) of the first protruding area 361. b may be a horizontal length (e.g., a length in the X direction) of the first protruding area 361. c may be half of a diagonal length (e.g., a length in the X direction) of an area where the shielding sheet 340 is expanded by the first protruding area 361. d may be a length (e.g., a length in a Z direction) of the first protruding area 361 protruding from the second surface 352 of the bracket 350. Additionally, the shielding sheet 340 may have a maximum elasticity of k.

In an embodiment, b and d may be the lengths of the first protruding area 361, and k may be an eigenvalue of the shielding sheet 340, and the minimum diameter a+b+a of the first open area 371 may be calculated using these values. For example, c may be (a² + d²)^{1/2}, and since c is a deformation length of the shielding sheet 340, c may be equal to the product of k and a. Also, a may be (d²/(k²-1))^{1/2}.

However, this is only an example calculation method, and a diameter of the first open area 371 in actual implementation may vary based on the shape and structure of the first protruding area 361 and the first open area 371, and may be greater or less than a calculated minimum diameter.

In an embodiment, the shield can 330 may include at least two edge areas (e.g., a third edge area 335 and a fourth edge area 336). The third edge area 335 may refer to an edge surrounding the first open area 371 on the first surface 331 of the shield can 330. The fourth edge area 336 may refer to an edge surrounding the first open area 371 on the second surface 332 of the shield can 330.

In an embodiment, the third edge area 335 may be formed in a round shape. For example, the third edge area 335 may be formed round through a chamfering process or a sanding process.

In an embodiment, since the third edge area 335 is in contact with the expanding area of the shielding sheet 340, there may be a risk that the shielding sheet 340 may be damaged or torn when the third edge area 335 presses against the shielding sheet 340. The third edge area 335 may reduce damage to the shielding sheet 340 through its round shape and provide durability and stability to the electronic device 301.

In an embodiment, a burr may be formed in the third edge area 335 or the fourth edge area 336 of the shield can 330 during a formation process of the first open area 371. The electronic device 301 may form the first open area 371 such that the burr is formed in the fourth edge area 336. For example, a drilling direction of the shield can 330 may be designed in the second direction so that the burr is not formed in the third edge area 335. In this manner, damage inflicted by the third edge area 335 on the shielding sheet 340 may be reduced, and durability and stability of the electronic device 301 may be provided.

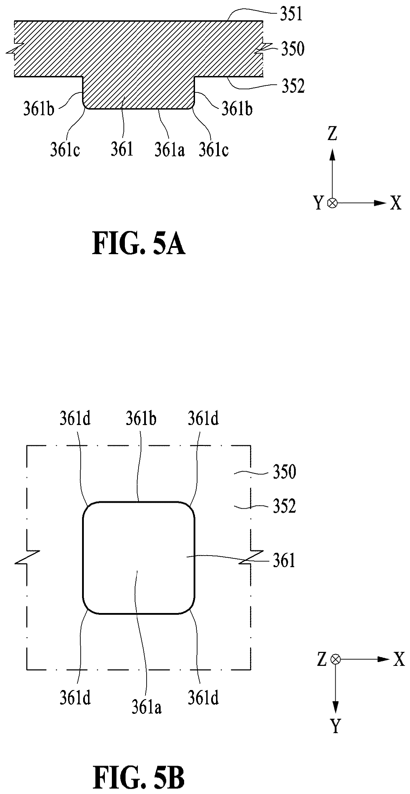

FIG. 5A is a schematic view of a cross-section of a portion of the bracket 350 according to an embodiment, and FIG. 5B is a schematic view of a bottom surface of a portion of the bracket 350 according to an embodiment.

Referring to FIGS. 5A and 5B, the first protruding area 361 according to an embodiment may include a first bottom surface 361a, a first side surface 361b, and a first edge area 361c.

Hereinafter, the description provided above is not repeated, and it is obvious that a partial configuration or structure of the bracket 350 and the electronic device 301 including the bracket 350 may be replaced, added, or omitted within a scope easily understandable by one of ordinary skill in the art with reference to the following drawings and descriptions. In addition, at least one component or feature of the embodiments described above may be coupled to the bracket 350 and the electronic device 301 including the bracket 350 unless this is technically and clearly infeasible.

In an embodiment, the first bottom surface 361a may be a surface of the first protruding area 361 facing downward (e.g., in the -Z direction) or facing the second direction. The first bottom surface 361a may be a surface that comes into contact with a shielding sheet (e.g., the shielding sheet 340 of FIG. 4).

In an embodiment, the first bottom surface 361a may have a polygonal, circular, or elliptical shape based on a direction (e.g., the viewing direction of FIG. 5B) viewed in the first direction (e.g., the +Z direction). Since the first bottom surface 361a is in contact with the expanding area of the shielding sheet 340, there may be a risk that the shielding sheet 340 may be damaged or torn when the first bottom surface 361a presses against the shielding sheet 340.

In an embodiment, the first bottom surface 361a may be formed in a circular or elliptical shape. Alternatively, the first bottom surface 361a may be formed in a polygonal shape with a rounded vertex 361d. For example, as shown in FIG. 5B, the first bottom surface 361a may have a rectangular shape including four rounded vertices 361d. In this manner, damage inflicted by the first protruding area 361 on the shielding sheet 340 may be reduced, and durability and stability of the electronic device 301 may be provided.

In an embodiment, the first side surface 361b may be a surface extending from the second surface 352 of the bracket 350 toward the first bottom surface 361a. As illustrated in FIG. 5A, the first side surface 361b may extend substantially perpendicularly in the second direction from the second surface 352 of the bracket 350. A range over which the first side surface 361b extends substantially perpendicularly may include a 90 degree range as well as a range of +/-3 degrees, +/-5 degrees, +/-7 degrees, +/-10 degrees, or +/-15 degrees.

Although not shown in the drawings, the first side surface 361b may extend inclinedly in an inward direction of the first protruding area 361 based on the second surface 352 of the bracket 350. For example, referring to the cross-section of FIG. 5A, a surface in a +X direction of the first side surface 361b may be formed as a shape that is simultaneously inclined in the -Z direction and the -X direction from the second surface 352 of the bracket 350. Alternatively, a surface in the -X direction of the first side surface 361b may be formed in a shape that is simultaneously inclined in the -Z direction and the +X direction from the second surface 352 of the bracket 350.

In an embodiment, the first side surface 361b may be extended inclinedly so that at least a portion of the shielding sheet 340 may be in contact with the first side surface 361b. In this manner, damage inflicted by the first protruding area 361 on the shielding sheet 340 may be reduced, and durability and stability of the electronic device 301 may be provided.

In an embodiment, the first edge area 361c may be a surface where the first bottom surface 361a and the first side surface 361b meet. The first edge area 361c may be formed in a round shape. Since the first edge area 361c is in contact with the expanding area of the shielding sheet 340, there may be a risk that the shielding sheet 340 may be damaged or torn when the first edge area 361c presses against the shielding sheet 340. The first edge area 361c may reduce damage to the shielding sheet 340 through its round shape and provide durability and stability to the electronic device 301.

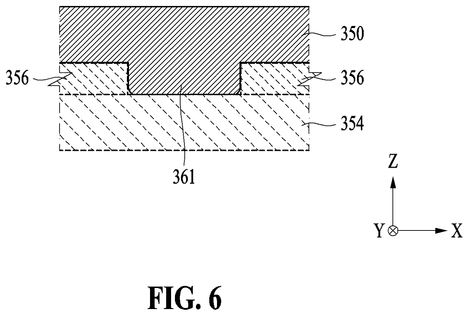

FIG. 6 is a schematic view illustrating a processing state of the bracket 350 according to an embodiment.

Referring to FIG. 6, the first protruding area 361 may be integrally formed with the bracket 350.

Hereinafter, the description provided above is not repeated, and it is obvious that a partial configuration or structure of the bracket 350 and the electronic device 301 including the bracket 350 may be replaced, added, or omitted within a scope easily understandable by one of ordinary skill in the art with reference to the following drawings and descriptions. In addition, at least one component or feature of the embodiments described above may be coupled to the bracket 350 and the electronic device 301 including the bracket 350 unless this is technically and clearly infeasible.

In an embodiment, the first protruding area 361 may be formed in the bracket 350 through at least two cutting or polishing processes. For example, as illustrated in FIG. 6, raw materials 354 and 356 of the bracket 350 may be processed at least twice to form the bracket 350 including the first protruding area 361.

In an embodiment, the raw materials 354, 356, and 350 of the bracket 350 may be processed through primary processing to remove the first processing area 354. Through primary processing, a bottom surface (e.g., the first bottom surface 361a of FIGS. 5A and 5B) of the first protruding area 361 may be formed.

In an embodiment, the first processed materials 356 and 350 of the bracket 350 may be processed through secondary processing to remove the second processing area 356. Through secondary processing, a side surface (e.g., the first side surface 361b of FIGS. 5A and 5B) of the first protruding area 361 may be formed.

In an embodiment, the bracket 350 may be formed of a metal material, and through at least two processing steps, the first protruding area 361 may be integrally formed with the bracket 350.

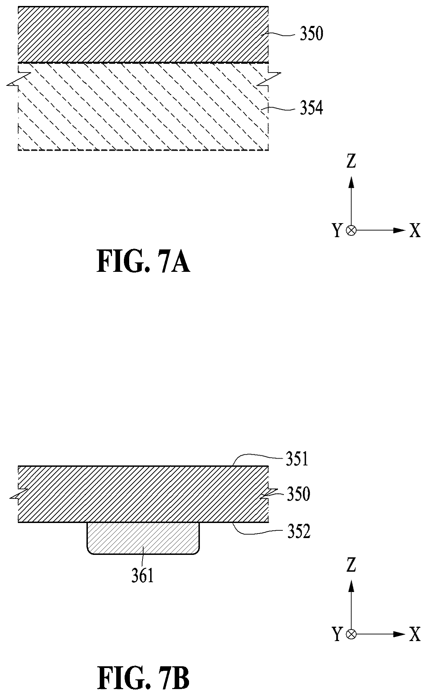

FIG. 7A is a schematic view illustrating a processing state of the bracket 350 according to an embodiment, and FIG. 7B is a schematic view illustrating a processing state of the bracket 350 according to an embodiment.

Referring to FIGS. 7A and 7B, the first protruding area 361 according to an embodiment may be formed by being attached to the bracket 350.

Hereinafter, the description provided above is not repeated, and it is obvious that a partial configuration or structure of the bracket 350 and the electronic device 301 including the bracket 350 may be replaced, added, or omitted within a scope easily understandable by one of ordinary skill in the art with reference to the following drawings and descriptions. In addition, at least one component or feature of the embodiments described above may be coupled to the bracket 350 and the electronic device 301 including the bracket 350 unless this is technically and clearly infeasible.

In an embodiment, the first protruding area 361 may be formed in the bracket 350 through at least one cutting or polishing process and an attachment process. For example, the raw materials 354 and 350 of the bracket 350 may be processed at least once and a conductive material may be attached to form the bracket 350 including the first protruding area 361.

In an embodiment, as illustrated in FIG. 7A, the raw materials 354 and 350 of the bracket 350 may be processed through primary processing to remove the first processing area 354. Through primary processing, the second surface 352 (e.g., the second surface 352 of FIGS. 5A and 5B) of the bracket 350 may be formed.

In an embodiment, as illustrated in FIG. 7B, the first protruding area 361 made of a conductive material may be attached to a surface of the bracket 350. For example, the first protruding area 361 may be formed by attaching a conductive tape or a conductive film to a surface of the bracket 350. Alternatively, for example, a conductive cream or conductive paste may be dropped on a surface of the bracket 350 and cured to form the first protruding area 361.

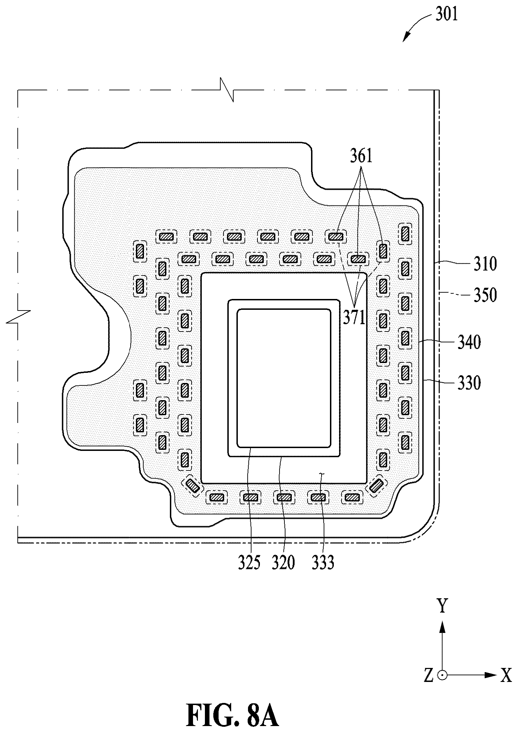

FIG. 8A is a plan view of the electronic device 301 according to an embodiment. Specifically, FIG. 8A is a plan view of the electronic device 301 viewed in a second direction (e.g., a -Z direction or downward direction) from the bracket 350 of the electronic device 301.

Referring to FIG. 8A, the electronic device 301 according to an embodiment may include a plurality of first protruding areas 361.

Hereinafter, the description provided above is not repeated, and it is obvious that a portion of the configuration and structure of the electronic device 301 may be replaced, added, or omitted within a scope easily understandable by one of ordinary skill in the art with reference to the following drawings and descriptions. In addition, at least one component or feature of the embodiments described above may be coupled to the electronic device 301 unless this is technically and clearly infeasible.

In an embodiment, the electronic device 301 may include a plurality of first protruding areas 361. Additionally, the electronic device 301 may include a plurality of first open areas 371 corresponding to the first protruding areas 361.

For example, a single first protruding area 361 and a single first open area 371 may form a pair. Hereinafter, the configuration of the electronic device 301 is described based on a pair of first protruding areas 361 and first open areas 371, but the actual implementation of the electronic device 301 is not limited thereto, and for example, a single first open area 371 may be formed for at least two first protruding areas 361.

In an embodiment, the plurality of first protruding areas 361 may be arranged in a direction surrounding the integrated circuit 320. For example, when the electronic device 301 is viewed in a plane direction (e.g., the second direction or the -Z direction), the plurality of first protruding areas 361 may be arranged to surround an outer peripheral surface of the integrated circuit 320. Each of the plurality of first open areas 371 may be provided at a position corresponding to each of the plurality of first protruding areas 361.

In an embodiment, a plurality of first protruding areas 361 may be arranged to surround the integrated circuit 320, thereby ensuring electrical or physical connection between the shielding sheet 340 and the bracket 350, or improving the shielding performance of the shield can 330.

In an embodiment, the plurality of first protruding areas 361 may be arranged in a plurality of rows surrounding the integrated circuit 320. For example, a portion of the plurality of first protruding areas 361 may be arranged in a row adjacent to the outer peripheral surface of the integrated circuit 320, and another portion of the plurality of first protruding areas 361 may be arranged in at least one row adjacent to the outer peripheral surface of the integrated circuit 320 with another row therebetween. In this manner, the electrical or physical connection of the shielding sheet 340 and the bracket 350 may be stably ensured, or the shielding performance of the shield can 330 may be further improved.

In an embodiment, the plurality of first protruding areas 361 may be arranged in a zigzag pattern when the electronic device 301 is viewed in a plane direction (e.g., the second direction or the -Z direction). Alternatively, the plurality of first protruding areas 361 may be arranged so that at least a portion of the first protruding areas 361 are spaced apart in the plane direction when the electronic device 301 is viewed in the plane direction (e.g., the second direction or the -Z direction). Alternatively, the plurality of first protruding areas 361 may be arranged irregularly when the electronic device 301 is viewed in a plane direction (e.g., the second direction or the -Z direction). In this manner, the electrical or physical connection of the shielding sheet 340 and the bracket 350 may be stably ensured.

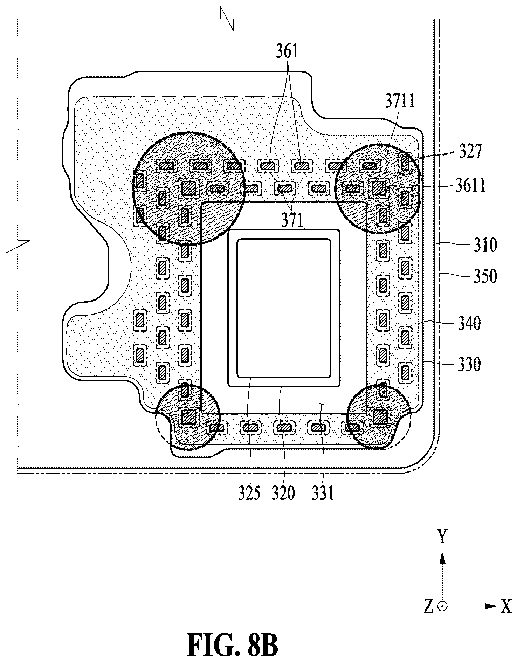

FIG. 8B is a plan view of the electronic device 301 according to an embodiment. Specifically, FIG. 8B is a plan view of the electronic device 301 viewed in a second direction (e.g., a -Z direction or downward direction) from the bracket 350 of the electronic device 301.

Referring to FIG. 8B, the first open area 371 may be used to inject a heat dissipation material 327 into the shield can 330.

Hereinafter, the description provided above is not repeated, and it is obvious that a portion of the configuration and structure of the electronic device 301 may be replaced, added, or omitted within a scope easily understandable by one of ordinary skill in the art with reference to the following drawings and descriptions. In addition, at least one component or feature of the embodiments described above may be coupled to the electronic device 301 unless this is technically and clearly infeasible.

In an embodiment, the first open area 371 may include an injection open area 3711. The injection open area 3711 may refer to the first open area 371 used to inject the heat dissipation material 327.

For example, at least a portion of the plurality of first open areas 371 may be used as the injection open area 3711. Alternatively, when the electronic device 301 includes a single first open area 371, the single first open area 371 may be used as the injection open area 3711.

In an embodiment, the heat dissipation material 327 may be injected into the shield can 330 through the injection open area 3711. When the heat dissipation material 327 is injected and cured before the shield can 330 is assembled to the substrate 310, additional tolerance may occur due to the heat dissipation material 327, or the heat dissipation material 327 may be injected beyond a position where the shield can 330 is to be assembled, which may affect the assembly of the shield can 330.

In an embodiment, the first open area 371 may be used as a space for injecting the heat dissipation material 327 into the shield can 330 after the shield can 330 is assembled. In this manner, heat dissipation performance of the electronic device 301 may be improved, and production yield and efficiency of the electronic device 301 may be improved.

In an embodiment, the injection open area 3711 may be formed to be greater in size than other first open areas 371. Additionally, among the plurality of first protruding areas 361, a predetermined first protruding area 3611 corresponding to the injection open area 3711 may be greater in size than other first protruding areas 361. By forming a large injection open area 3711, injection of the heat dissipation material 327 may be made easy and convenient. However, this is only an example embodiment, and the actual implementation of the injection open area 3711 is not limited thereto, and the injection open area 3711 may have the same or similar size and shape as the other first open areas 371.

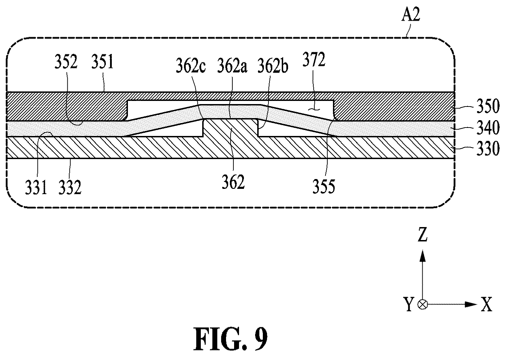

FIG. 9 is a schematic view of a cross-section of a portion of the electronic device 301 according to an embodiment. Specifically, FIG. 9 is a diagram illustrating area A2, which is a portion of area A shown in FIG. 3C.

When including FIG. 9, the electronic device 301 according to an embodiment may include a second protruding area 362 and a second open area 372.

Hereinafter, the description provided above is not repeated, and it is obvious that a portion of the configuration and structure of the electronic device 301 may be replaced, added, or omitted within a scope easily understandable by one of ordinary skill in the art with reference to the following drawings and descriptions. In addition, at least one component or feature of the embodiments described above may be coupled to the electronic device 301 unless this is technically and clearly infeasible.

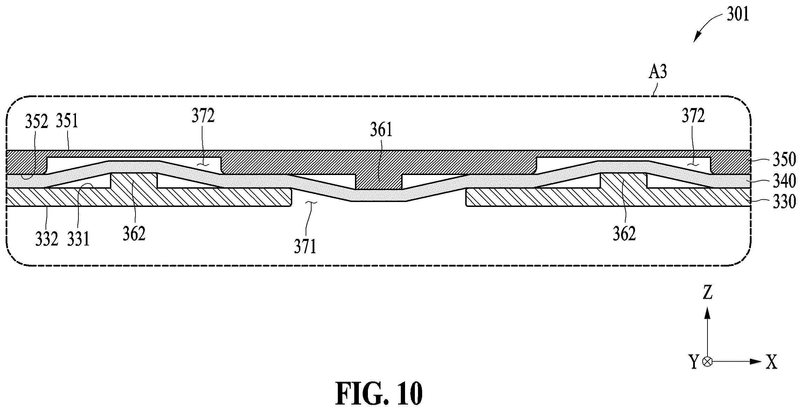

In an embodiment, the area A1 of FIG. 4 and the area A2 of FIG. 9 may be independent embodiments, and the electronic device 301 may include only one of the area A1 and the area A2. Alternatively, the electronic device 301 may include both the area A1 and the area A2. Regarding area A3, which is an example that includes both area A1 and area A2, a description is provided with reference to FIG. 10.

In an embodiment, the second protruding area 362 may be provided on the first surface 331 of the shield can 330. The second protruding area 362 may be formed to protrude in the first direction from the first surface 331 of the shield can 330.

In an embodiment, the second protruding area 362 may press the shielding sheet 340. The second protruding area 362 may protrude more than other areas of the first surface 331 of the shield can 330 so as to press the shielding sheet 340 and come into contact with the shielding sheet 340.

In an embodiment, the second open area 372 may be provided in the bracket 350. The second open area 372 may be provided at a position facing the second protruding area 362. The second open area 372 may be a space for positioning the second protruding area 362 and the shielding sheet 340 protruding in the first direction by the second protruding area 362.

In an embodiment, the second protruding area 362 and the second open area 372 may provide contact stability between the bracket 350 and the shielding sheet 340, and may improve the shielding performance of the shield can 330 and the shielding sheet 340 of the electronic device 301.

In an embodiment, when the shielding sheet 340 and the bracket 350 do not make contact or a poor contact occurs, the shield can 330 and the bracket 350 may not be electrically conductive, and the inside of the shield can 330 may not be shielded from the outside.

For example, the bracket 350 may be spaced or separated from the shielding sheet 340 by an amount of TIM 325 applied or by a mechanical tolerance of the shield can 330 and the bracket 350. In this case, electromagnetic waves and noise generated from the integrated circuit 320 may be emitted to the outside of the shield can 330 and may affect the operation of other electronic components.

In an embodiment, the second protruding area 362 and the second open area 372 may ensure electrical or physical connection of the shielding sheet 340 and the bracket 350, or improve the shielding performance of the shield can 330. Alternatively, the electronic device 301 may prevent shielding defects due to mechanical tolerance and improve production yield and efficiency through the second protruding area 362 and the second open area 372.

The second open area 372 of an embodiment may be formed as a groove sunken inward from the second surface 352 of the bracket 350. The second open area 372 formed as a groove may improve durability of the bracket 350 and protect the bracket 350 from water or foreign substances from entering from the outside through the second open area 372.

In an embodiment, a method of calculating a minimum diameter (e.g., a diameter in an X direction) of the second open area 372 may be applied by referring to the method of calculating the minimum diameter of the first open area 371 described above with reference to FIG. 4.

In an embodiment, the bracket 350 may include at least one fifth edge area 355. The fifth edge area 355 may refer to an edge surrounding the second open area 372 on the second surface 352 of the bracket 350.

In an embodiment, the fifth edge area 355 may be formed in a round shape. For example, the fifth edge area 355 may be formed round through a chamfering process or a sanding process.

In an embodiment, since the fifth edge area 355 is in contact with the expanding area of the shielding sheet 340, there may be a risk that the shielding sheet 340 may be damaged or torn when the fifth edge area 355 presses against the shielding sheet 340. The fifth edge area 355 may reduce damage to the shielding sheet 340 through its round shape and provide durability and stability to the electronic device 301.

In an embodiment, the second protruding area 362 may include a second bottom surface 362a, a second side surface 362b, and a second edge area 362c.

In an embodiment, the second bottom surface 362a may be a surface of the second protruding area 362 facing upward (e.g., in a +Z direction) or facing the first direction. Alternatively, the second bottom surface 362a may be a surface that comes into contact with the shielding sheet 340.

In an embodiment, the second bottom surface 362a may have a polygonal, circular, or elliptical shape based on a direction viewed in the second direction. Since the second bottom surface 362a is in contact with the expanding area of the shielding sheet 340, there may be a risk that the shielding sheet 340 may be damaged or torn when the second bottom surface 362a presses against the shielding sheet 340.

In an embodiment, the second bottom surface 362a may be formed in a circular or elliptical shape. Alternatively, the second bottom surface 362a may be formed in a polygonal shape with rounded vertices. For example, the second bottom surface 362a may have a rectangular shape including four rounded vertices. In this manner, damage inflicted by the second protruding area 362 on the shielding sheet 340 may be reduced, and durability and stability of the electronic device 301 may be provided.

In an embodiment, the second side surface 362b may be a surface extending from the first surface 331 of the shield can 330 toward the second bottom surface 362a. As illustrated in FIG. 9, the second side surface 362b may extend substantially perpendicularly in the first direction from the first surface 331 of the shield can 330. A range over which the first side surface 361b extends substantially perpendicularly may include a 90 degree range as well as a range of +/-3 degrees, +/-5 degrees, +/-7 degrees, +/-10 degrees, or +/-15 degrees.

Although not shown in the drawings, the second side surface 362b may extend inclinedly in an inward direction of the second protruding area 362 based on the first surface 331 of the shield can 330. For example, referring to the cross-section of FIG. 9, a surface in a +X direction of the second side surface 362b may be formed into a shape that is simultaneously inclined in a +Z direction and a -X direction from the first surface 331 of the shield can 330. Alternatively, a surface in the -X direction of the second side surface 362b may be formed in a shape that is simultaneously inclined in the +Z direction and the +X direction from the first surface 331 of the shield can 330.

In an embodiment, the second side surface 362b may be extended inclinedly so that at least a portion of the shielding sheet 340 may be in contact with the second side surface 362b. In this manner, damage inflicted by the second protruding area 362 on the shielding sheet 340 may be reduced, and durability and stability of the electronic device 301 may be provided.

In an embodiment, the second edge area 362c may be a surface where the second bottom surface 362a and the second side surface 362b meet. The second edge area 362c may be formed in a round shape. Since the second edge area 362c is in contact with the expanding area of the shielding sheet 340, there may be a risk that the shielding sheet 340 may be damaged or torn when the second edge area 362c presses against the shielding sheet 340. The second edge area 362c may reduce damage to the shielding sheet 340 through its round shape and provide durability and stability to the electronic device 301.

In an embodiment, the description of the first protruding area 361 provided above may be applied equally or similarly to the second protruding area 362. Additionally, the description of the first open area 371 provided above may be applied equally or similarly to the second open area 372.

FIG. 10 is a schematic view of a cross-section of a portion of the electronic device 301 according to an embodiment. Specifically, FIG. 10 is a diagram illustrating area A3, which is a portion of area A shown in FIG. 3C.

Referring to FIG. 10, the electronic device 301 according to an embodiment may include all of the first protruding area 361, the second protruding area 362, the first open area 371, and the second open area 372.

Hereinafter, the description provided above is not repeated, and it is obvious that a portion of the configuration and structure of the electronic device 301 may be replaced, added, or omitted within a scope easily understandable by one of ordinary skill in the art with reference to the following drawings and descriptions. In addition, at least one component or feature of the embodiments described above may be coupled to the electronic device 301 unless this is technically and clearly infeasible.

In an embodiment, a single first protruding area 361 and a single first open area 371 may form a pair. Additionally, a single second protruding area 362 and a single second open area 372 may form a pair.

In an embodiment, the electronic device 301 may include both a pair of the first protruding area 361 and the first open area 371 and a pair of the second protruding area 362 and the second open area 372.

For example, a pair of the first protruding area 361 and the first open area 371 may be spaced apart from and adjacent to a pair of the second protruding area 362 and the second open area 372. In this manner, the electronic device 301 may ensure electrical or physical connection of the shielding sheet 340 and the bracket 350, or improve shielding performance of the shield can 330. Alternatively, the electronic device 301 may prevent shielding defects due to mechanical tolerance and improve production yield and efficiency.

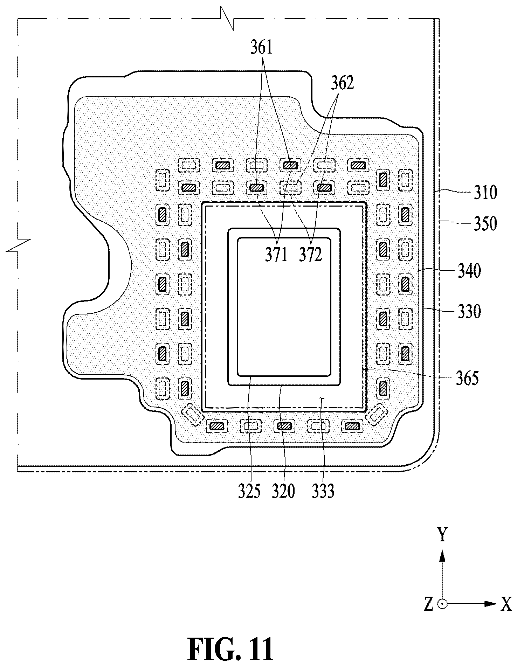

FIG. 11 is a plan view of the electronic device 301 according to an embodiment. Specifically, FIG. 11 is a plan view of the electronic device 301 viewed in a second direction (e.g., a -Z direction or downward direction) from the bracket 350 of the electronic device 301.

Referring to FIG. 11, a plurality of first protruding areas 361 and a plurality of second protruding areas 362 according to an embodiment may be arranged alternately in a direction surrounding the integrated circuit 320.

Hereinafter, the description provided above is not repeated, and it is obvious that a portion of the configuration and structure of the electronic device 301 may be replaced, added, or omitted within a scope easily understandable by one of ordinary skill in the art with reference to the following drawings and descriptions. In addition, at least one component or feature of the embodiments described above may be coupled to the electronic device 301 unless this is technically and clearly infeasible.

In an embodiment, the electronic device 301 may include a plurality of second protruding areas 362. Additionally, the electronic device 301 may include a plurality of second open areas 372 corresponding to the second protruding areas 362.

For example, a single second protruding area 362 and a single second open area 372 may form a pair. Hereinafter, the configuration of the electronic device 301 is described based on a pair of the second protruding area 362 and the second open area 372, but the actual implementation of the electronic device 301 is not limited thereto, and for example, a single second open area 372 may be formed for at least two second protruding areas 362.

In an embodiment, the plurality of second protruding areas 362 may be arranged in a direction surrounding the integrated circuit 320. For example, when the electronic device 301 is viewed in a plane direction (e.g., the second direction or the -Z direction), the plurality of second protruding areas 362 may be arranged to surround an outer peripheral surface of the integrated circuit 320. Each of the plurality of second open areas 372 may be provided at a position corresponding to each of the plurality of second protruding areas 362.

In an embodiment, a plurality of second protruding areas 362 may be arranged to surround the integrated circuit 320, thereby ensuring electrical or physical connection between the shielding sheet 340 and the bracket 350, or improving the shielding performance of the shield can 330.

In an embodiment, a plurality of first protruding areas 361 and a plurality of second protruding areas 362 may be arranged in a plurality of rows surrounding the integrated circuit 320. For example, a portion of the plurality of first protruding areas 361 and the plurality of second protruding areas 362 may be arranged in a row adjacent to the outer peripheral surface of the integrated circuit 320, and another portion of the plurality of first protruding areas 361 and the plurality of second protruding areas 362 may be arranged in at least one row adjacent to the outer peripheral surface of the integrated circuit 320 with another row therebetween. In this manner, the electrical or physical connection of the shielding sheet 340 and the bracket 350 may be stably ensured, or the shielding performance of the shield can 330 may be further improved.

In an embodiment, at least a portion of the plurality of first protruding areas 361 and the plurality of second protruding areas 362 may be arranged alternately in a direction surrounding the integrated circuit 320 when the electronic device 301 is viewed in a plane direction (e.g., the second direction or the -Z direction). In this manner, the electrical or physical connection of the shielding sheet 340 and the bracket 350 may be stably ensured.

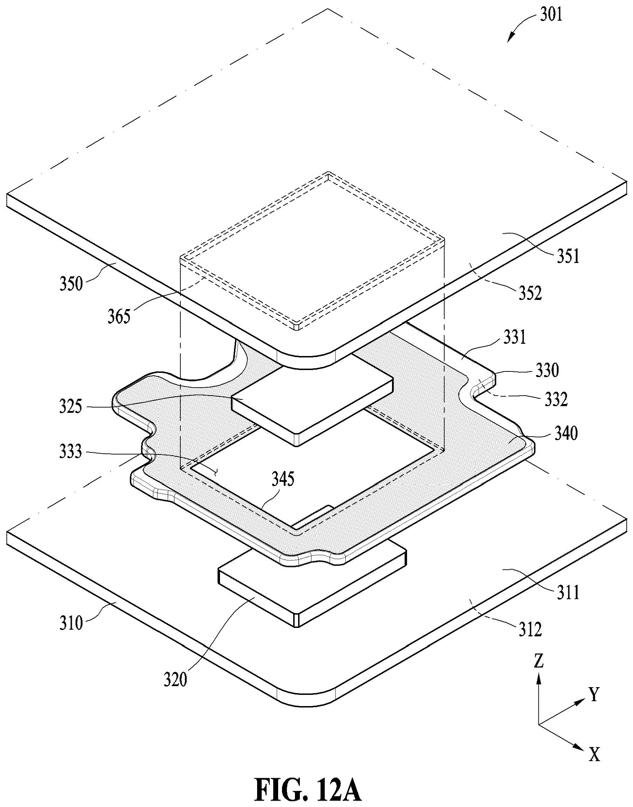

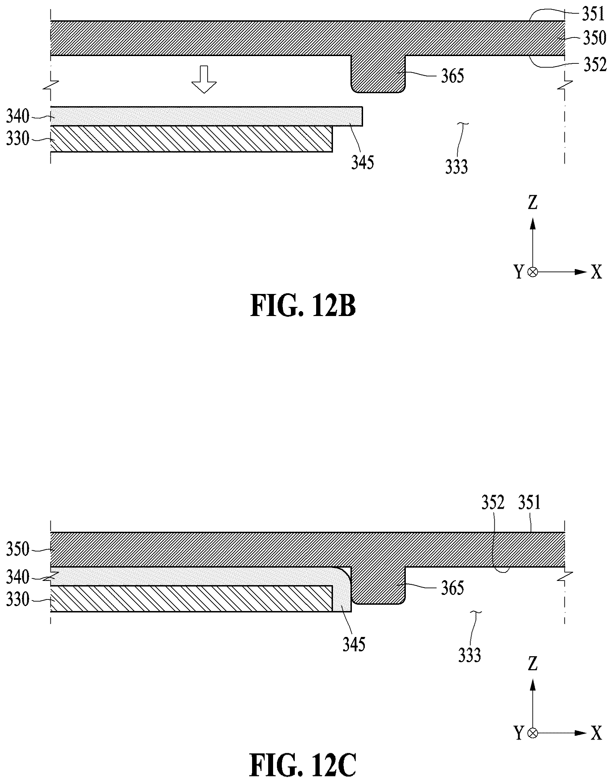

In an embodiment, a side wall 365 may be a structure protruding in the second direction from the bracket 350. The side wall 365 may extend to surround at least a portion of the opening 333. The side wall 365 according to an embodiment is described in detail with reference to FIGS. 12A, 12B, and 12C.

In an embodiment, as illustrated in FIG. 11, the side wall 365 may be spaced apart from the plurality of first protruding areas 361 and/or the plurality of second protruding areas 362 by a predetermined distance.

Without being limited thereto, at least a portion of the side wall 365 may be included in the first protruding area 361. Alternatively, at least a portion of the side wall 365 may be connected to the first protruding area 361. In an embodiment, when the side wall 365 is included or connected to the first protruding area 361, at least a portion of the opening 333 may be included or connected to the first open area 371. Electrical and/or physical bonding stability between the bracket 350 and the shield can 330 may be provided through a connection structure of the side wall 365 and the first protruding area 361.

FIG. 12A is an exploded perspective view of the electronic device 301 according to an embodiment, FIG. 12B is a schematic view of a cross-section of a portion of the electronic device 301 according to an embodiment, and FIG. 12C is a schematic view of a cross-section of a portion of the electronic device 301 according to an embodiment.

Referring to FIGS. 12A, 12B and 12C, the bracket 350 of the electronic device 301 according to an embodiment may include the side wall 365.

Hereinafter, the description provided above is not repeated, and it is obvious that a portion of the configuration and structure of the electronic device 301 may be replaced, added, or omitted within a scope easily understandable by one of ordinary skill in the art with reference to the following drawings and descriptions. In addition, at least one component or feature of the embodiments described above may be coupled to the electronic device 301 unless this is technically and clearly infeasible.

In an embodiment, the shielding sheet 340 may further include a side area 345. The side area 345 may be a portion of the shielding sheet 340 extending toward the center of the opening 333 of the shield can 330. Alternatively, the side area 345 may be a portion of the shield can 330 that faces a side surface surrounding the opening 333.

In an embodiment, the side wall 365 may be provided on the second surface 352 of the bracket 350. The side wall 365 may protrude and surround at least a portion of the opening 333 of the shield can 330. For example, the side wall 365 may have a shape corresponding to a shape of the opening 333, and the side wall 365 may have an outer diameter smaller than the opening 333.

In an embodiment, the side wall 365 may be in contact with the side area 345 of the shielding sheet 340. When the bracket 350 is inserted into the shield can 330, the side wall 365 may be inserted into the opening 333, and the side area 345 protruding inside the opening 333 may come into contact with the side wall 365.

For example, FIGS. 12B and 12C are schematic views illustrating an example operation in which the bracket 350 is assembled to the shield can 330 during an assembly process of the electronic device 301. Referring to FIGS. 12B and 12C, the side area 345 of the shielding sheet 340 may be folded and pressed by the side wall 365 of the bracket 350. The side area 345 may be in close contact with the side wall 365 in at least a portion of the side area 345.

In an embodiment, the side wall 365 and the side area 345 may ensure electrical or physical connection of the shielding sheet 340 and the bracket 350, or improve shielding performance of the shield can 330. Alternatively, the electronic device 301 may prevent shielding defects due to mechanical tolerance and improve production yield and efficiency through the side wall 365 and the side area 345.

The electronic device 301 according to an embodiment may include the substrate 310 including the first surface 311 facing a first direction, the integrated circuit 320 provided on the first surface 311 of the substrate 310, the shield can 330 provided on the first surface 311 of the substrate 310 and surrounding at least a portion of the integrated circuit 320, the bracket 350 provided in the first direction from the shield can 330, and the shielding sheet 340 provided between the bracket 350 and the shield can 330. In an embodiment, the bracket 350 may include the first protruding area 361 protruding from the surface 352 facing a second direction opposite the first direction. In an embodiment, the shield can 330 may include the first open area 371 provided at a position facing the first protruding area 361.

In an embodiment, the first protruding area 361 may include the first bottom surface 361a facing the second direction, the first side surface 361b extending from the surface 352 facing the second direction of the bracket 350 toward the first bottom surface 361a, and the first edge area 361c where the first bottom surface 361a and the first side surface 361b meet.

In an embodiment, the first edge area 361c may be formed in a round shape.

In an embodiment, the first bottom surface 361a may be formed in a polygonal shape with the rounded vertex 361d.

In an embodiment, the first side surface 361b may extend inclinedly in an inward direction of the first protruding area 361 based on the surface 352 facing the second direction of the bracket 350.

In an embodiment, the electronic device 301 may include a plurality of first protruding areas 361. In an embodiment, the plurality of first protruding areas 361 may be arranged in a direction surrounding the integrated circuit 320.

In an embodiment, the shield can 330 may further include a second protruding area 362 protruding from a surface 331 facing the first direction. In an embodiment, the bracket 350 may further include a second open area 372 provided at a position facing the second protruding area 362.

In an embodiment, the second protruding area 362 may include the second bottom surface 362a facing the first direction, the second side surface 362b extending from the surface 331 of the shield can 330 facing the first direction toward the second bottom surface 362a, and the second edge area 362c where the second bottom surface 362a and the second side surface 362b meet.

In an embodiment, the second edge area 362c may be formed in a round shape.

In an embodiment, the second bottom surface 362a may be formed in a polygonal shape with rounded vertices.

In an embodiment, the second side surface 362b may extend inclinedly in an inward direction of the second protruding area 362 based on the surface 331 of the shield can 330 facing the first direction.

In an embodiment, the electronic device 301 may include a plurality of second protruding areas 362. In an embodiment, the plurality of second protruding areas 362 may be arranged in a direction surrounding the integrated circuit 320.

In an embodiment, the shield can 330 may include the third edge area 335 surrounding the first open area 371 on the surface 331 facing the first direction. In an embodiment, the third edge area 335 may be formed in a round shape.

In an embodiment, the shield can 330 may include the opening 333 provided at a position facing the integrated circuit 320. In an embodiment, the bracket 350 may include the side wall 365 protruding from the surface 352 facing the second direction and surrounding at least a portion of the opening 333 of the shield can 330.

In an embodiment, the bracket 350 may be formed of a metal material. The first protruding area 361 may be integrally formed with the bracket 350.

In an embodiment, the first protruding area 361 may be formed of a conductive material that may be attached to a portion of the bracket 350.

In an embodiment, the first open area 371 may be formed as a hole opening from the surface 331 of the shield can 330 facing the first direction to another surface 332 facing the opposite direction.

In an embodiment, the first open area 371 may be formed as a groove that is sunken inward from the surface 331 of the shield can 330 facing the first direction.

Additionally, the electronic device 301 according to an embodiment may include the substrate 310 including the first surface 311 facing the first direction, the integrated circuit 320 provided on the first surface 311 of the substrate 310, the shield can 330 provided on the first surface 311 of the substrate 310 and surrounding at least a portion of the integrated circuit 320, the bracket 350 provided in the first direction from the shield can 330 and including the first protruding area 361 protruding from the surface 352 facing the second direction opposite the first direction, and the shielding sheet 340 provided between the bracket 350 and the shield can 330. In an embodiment, the shield can 330 may include the first open area 371 provided at a position facing the first protruding area 361 and the second protruding area 362 protruding from the surface 331 facing the first direction. In an embodiment, the bracket 350 may further include the second open area 372 provided at a position facing the second protruding area 362.

In an embodiment, the electronic device 301 may include a plurality of first protruding areas 361 and a plurality of second protruding areas 362.

In an embodiment, at least a portion of the plurality of first protruding areas 361 and the plurality of second protruding areas 362 may be arranged alternately in a direction surrounding the integrated circuit 320.

While embodiments have been illustrated and described above, the disclosure is not limited to the aforementioned specific embodiments. Those skilled in the art should appreciate that various modifications may be made to the embodiments without departing from the subject matter of the disclosure as defined by the appended claims, and also that such modifications are not to be understood individually from the technical spirit or prospect of the disclosure.

## Claims

1. An electronic device (301), comprising:
a substrate (310) comprising a first surface (311) facing a first direction;
an integrated circuit (320) provided on the first surface (311) of the substrate (310);
a shield can (330) provided on the first surface (311) of the substrate (310) and surrounding at least a portion of the integrated circuit (320);
a bracket (350) provided in the first direction from the shield can (330); and
a shielding sheet (340) provided between the bracket (350) and the shield can (330),
wherein the bracket (350) comprises a first protruding area (361) protruding from a surface (352) facing a second direction opposite the first direction, and
the shield can (330) comprises a first open area (371) provided at a position facing the first protruding area (361).

2. The electronic device (301) of claim 1,
wherein the first protruding area (361) comprises:
a first bottom surface (361a) facing the second direction,
a first side surface (361b) extending from the surface (352) facing the second direction of the bracket (350) toward the first bottom surface (361a), and
a first edge area (361c) where the first bottom surface (361a) and the first side surface (361b) meet.

3. The electronic device (301) of claims 1 or 2,
wherein the first edge area (361c) is formed in a round shape.

4. The electronic device (301) of any one of claims 1 to 3,
wherein the first bottom surface (361a) is formed in a polygonal shape with a rounded vertex (361d).

5. The electronic device (301) of any one of claims 1 to 4,
wherein the first side surface (361b) extends inclinedly in an inward direction of the first protruding area (361) based on the surface (352) facing the second direction of the bracket (350).

6. The electronic device (301) of any one of claims 1 to 5,
wherein the electronic device (301) comprises a plurality of the first protruding areas (361),
wherein the plurality of first protruding areas (361) is arranged in a direction surrounding the integrated circuit (320).

7. The electronic device (301) of any one of claims 1 to 6,
wherein the shield can (330) further comprises a second protruding area (362) protruding from a surface (331) facing the first direction, and
the bracket (350) further comprises a second open area (372) provided at a position facing the second protruding area (362).

8. The electronic device (301) of any one of claims 1 to 7,
wherein the second protruding area (362) comprises:
a second bottom surface (362a) facing the first direction,
a second side surface (362b) extending from the surface (331) of the shield can (330) facing the first direction toward the second bottom surface (362a), and
a second edge area (362c) where the second bottom surface (362a) and the second side surface (362b) meet.

9. The electronic device (301) of any one of claims 1 to 8,
wherein the second edge area (362c) is formed in a round shape.

10. The electronic device (301) of any one of claims 1 to 9,
wherein the second bottom surface (362a) is formed in a polygonal shape with rounded vertices.

11. The electronic device (301) of any one of claims 1 to 10,
wherein the second side surface (362b) extends inclinedly in an inward direction of the second protruding area (362) based on the surface (331) of the shield can (330) facing the first direction.

12. The electronic device (301) of any one of claims 1 to 11,
wherein the electronic device (301) comprises a plurality of the second protruding areas (362),
wherein the plurality of second protruding areas (362) is arranged in a direction surrounding the integrated circuit (320).

13. The electronic device (301) of any one of claims 1 to 12,
wherein the shield can (330) comprises a third edge area (335) surrounding the first open area (371) on the surface (331) facing the first direction,
wherein the third edge area (335) is formed in a round shape.

14. The electronic device (301) of any one of claims 1 to 13,
wherein the shield can (330) comprises an opening (333) provided at a position facing the integrated circuit (320), and
the bracket (350) comprises a side wall (365) protruding from the surface (352) facing the second direction and surrounding at least a portion of the opening (333) of the shield can (330).

15. The electronic device (301) of any one of claims 1 to 14,
wherein the bracket (350) is formed of a metal material, and
the first protruding area (361) is integrally formed with the bracket (350).
